(19) Europäisches Patentamt
European Patent Office
Office européen des brevets

(11) EP 0 598 445 B1

(12) EUROPEAN PATENT SPECIFICATION

(45) Date of publication and mention
of the grant of the patent:
11.02.1998 Bulletin 1998/07

(51) Int Cl.⁶: H03F 3/45, H03F 3/345

(21) Application number: 93203149.5

(22) Date of filing: 11.11.1993

(54) **MOS technology amplifier circuit**

Verstärkerschaltung in MOS Technologie

Circuit amplificateur en technologie MOS

(84) Designated Contracting States:
DE FR GB IT

(30) Priority: 17.11.1992 EP 92203520

(43) Date of publication of application:
25.05.1994 Bulletin 1994/21

(73) Proprietor: Philips Electronics N.V.
5621 BA Eindhoven (NL)

(72) Inventors:
• Seevinck, Evert, c/o Int. Octrooibureau B.V.
NL-5656 AA Eindhoven (NL)
• Bolt, Jacob Hendrik, c/o Int. Octrooibureau B.V.
NL-5656 AA Eindhoven (NL)

(74) Representative:
Evers, Johannes Hubertus Maria et al
INTERNATIONAAL OCTROOIBUREAU B.V,
Prof. Holstlaan 6
5656 AA Eindhoven (NL)

(56) References cited:
EP-A- 0 123 275          US-A- 4 068 184
US-A- 4 271 394          US-A- 4 568 885

## Description

The invention relates to a MOS technology amplifier circuit comprising a first series combination of the main current paths of a first and a second MOS transistor, the input of the amplifier circuit being coupled to the gate electrode of the first transistor, an output of the amplifier circuit being coupled to the drain electrode of the first transistor and the gate electrode of the second transistor being coupled to the drain electrode.

A circuit of this type is known from the book entitled "Analysis and design of analog integrated circuits", 2nd Edn., by Paul R. Gray and Robert G. Meyer, published by John Wiley & Sons, more specif. Fig. 12.13(a).

The voltage gain of such an amplifier is determined by the ratios of the channel dimensions of the transistors and is approximately equal to the square root of this ratio expressed as $\sqrt{k'}$. Since said gain ratio is unequal to one, the gate-source voltage $V_{GS}$ of the first transistor is unequal to that of the second transistor.

In the saturation zone the current produced by the drain electrode of a modern technology MOS transistor is in a proper approximation equal to:

$$I_D = \beta_0/2 \, \frac{(V_{GS} - V_T)^2}{1 + \theta \, (V_{GS} - V_T)} \, ,$$

where

$V_T$ is the power source electrode threshold voltage, $\beta_0 = \mu_0 C_{ox} \cdot (W/L)$ where $\mu_0$ is the average mobility of the load carrier in the channel region of a MOSFET transistor having a low channel field strength, $C_{ox}$ is the gate electrode capacity per surface unit, W is the width and L the length of the channel region and $\theta$ is a mobility reduction factor occurring at higher channel field strengths.

Document EP, 0,123,275 discloses a differential MOS amplifier circuit having a differential input section comprising two main current paths of two series connected transistors.

Due to the reduction factor $\theta$ and the unequal gate-source voltage $V_{GS}$ of the two transistors, the gain is not linear, so that distortion occurs.

It is an object of the invention to reduce this distortion considerably. The invention is defined by the appended claims. For this purpose, the amplifier circuit according to the invention comprises a second series combination identical with the first series combination and including the main current paths of a third and a fourth MOS transistor, another input of the amplifier circuit being coupled to the gate electrode of the third MOS transistor, the source electrodes of the first and third MOS transistors being intercoupled and coupled to a current source, the drain electrodes of the second and fourth MOS transistors being intercoupled, the drain electrodes of the first and third transistors being connected to a differential amplifier, the output of the differential amplifier being coupled to the output of the amplifier and also, *via* a series combination of a first and a second resistor, to the drain electrodes of the second and fourth MOS transistors, the junction of the first and second resistors being coupled to the gate electrode of the fourth transistor and the MOS transistors being mutually identical.

This amplifier circuit is advantageous in that the distortion due to the mobility reduction of the load carriers in the channel region is eliminated and that still a gain factor of the order of 10 to 100 may be realised.

This amplifier circuit further has the additional advantage of the gain factor being independent of the threshold voltage $V_T$ of the transistors.

According to a further embodiment of the invention the differential amplifier circuit comprises a third series combination of the main current paths of a fifth and a sixth MOS transistor, a fourth series combination identical with the third series combination and including the main current paths of a seventh and an eighth MOS transistor, the source electrodes of the fifth and seventh MOS transistors being interconnected and, *via* a second current source, connected to the drain electrodes of the second and fourth MOS transistors, the gate electrodes of the fifth and seventh MOS transistors together forming the input to the differential amplifier, the gate electrodes of the sixth and eighth MOS transistors being intercoupled and coupled to the drain electrode of the eighth MOS transistor, the amplifier circuit comprising a ninth MOS transistor whose source electrode is coupled to the source electrode of the sixth and eighth MOS transistors and a power supply terminal, the gate electrode being coupled to the drain electrode of the sixth transistor, the drain electrode of the ninth MOS transistor forming the output of the amplifier circuit, and the fifth and seventh MOS transistors being complementary to the further MOS transistors.

This embodiment is advantageous in that the operational amplifier comprises a minimum number of components, has a good dynamic range and in that a low supply voltage is sufficient for the amplifier circuit to operate.

The invention and its advantages will be further explained with reference to the embodiments showing in the drawing Figures, in which:

Fig. 1 shows an amplifier circuit according to the invention, and
Fig. 2 shows a preferred embodiment of the amplifier circuit as shown in fig. 1.

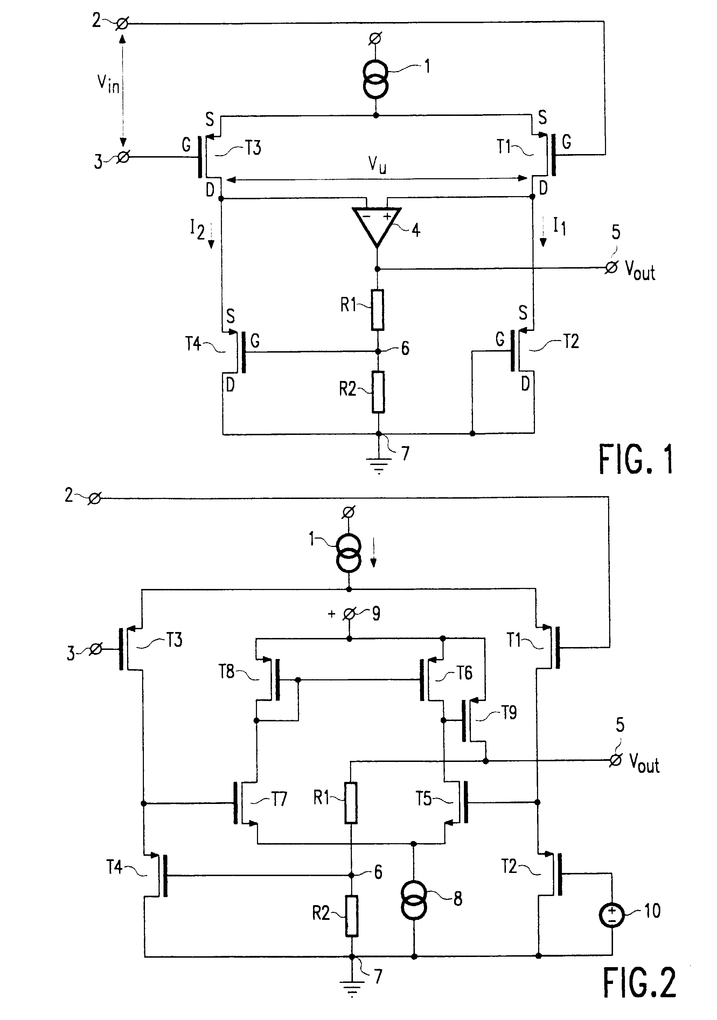

The basic circuit diagram of an amplifier circuit according to the invention shown in Fig. 1 comprises a first series combination of two MOSFET transistors, being a first transistor $T_1$ and a second transistor $T_2$, a second series combination of two further MOSFET transistors being a third transistor $T_3$ and a fourth transistor $T_4$. The source electrodes of the transistors $T_1$ and $T_3$ are interconnected and connected to a current source 1 and form what is commonly referred to as a long tailed pair. An input voltage $V_{in}$ applied to the input terminals 2 and 3 of the amplifier is applied to the gate electrodes of the transistor $T_1$ and $T_3$. The transistors $T_2$ and $T_4$ form the loads of the transistors $T_1$ and $T_3$. For this purpose, the source electrodes of the transistors $T_2$ and $T_4$ are connected to the drain electrodes of the transistors $T_1$ and $T_3$ and the drain electrodes of the transistors $T_2$ and $T_4$ as well as the gate electrode of transistor $T_2$ are connected to a point of fixed potential 7 (ground).

The output voltage $V_u$ of the circuit described thus far is tapped between the drain electrodes of the transistors $T_1$ and $T_3$.

For the explanation of the operation of the amplifier circuit according to the invention it is first assumed that also the gate electrode of the fourth transistor $T_4$ is connected to ground, that the transistors $T_1$ and $T_3$ as well as the transistors $T_2$ and $T_4$ are mutually identical and that the geometric ratio W/L of the transistors $T_1$ and $T_3$ is in the proportion to the geometric ratios of the transistors $T_2$ and $T_4$ to the ratio of K:1, W representing the width and L representing the length of the channel regions of the MOSFET transistors, so that:

$$\frac{W_1}{L_1} : \frac{W_2}{L_2} = K \text{ and that } \frac{W_3}{L_3} : \frac{W_4}{L_4} = K \qquad (1)$$

For the current $I_D$ flowing through the MOSFET transistors it holds in a first approximation in the saturation zone that:

$$I_D = \frac{\beta}{2} \cdot (V_{GS} - V_T)^2 \qquad (2)$$

where $V_T$ is a threshold voltage resulting from the integration process, $V_{GS}$ is the voltage between the gate and the source electrode, and

$$\beta = \mu_n C_{ox} \frac{W}{L} \qquad (3)$$

where $\mu_n$ is the average carrier (holes in this case) mobility in the channel region of the MOSFET transistor and $C_o$ is the gate electrode capacitance per surface unit.

From 2 it follows that:

$$V_{GS} = \sqrt{\frac{2I_D}{\beta}} + V_T \qquad (4)$$

Furthermore,

$$V_{in} = V_{GS_1} - V_{GS_3}$$

Substitution of (4) yields that:

$$V_{in} = \sqrt{\frac{2I_1}{\beta_1}} - \sqrt{\frac{2I_2}{\beta_1}} \qquad (5)$$

where $\beta_1$ of transistor $T_3$ is equal to $\beta_1$ of transistor $T_1$ due to the fact that the transistors are identical and thus also have equal W/L ratios.

Assuming that the gate electrode of $V_{GS4}$ is also grounded, for $V_u$ it holds that:

$$V_u = V_{GS_2} - V_{GS_4} \qquad (6)$$

Substitution of (4) and (6) yields that:

$$V_u = \sqrt{\frac{2I_1}{\beta_2}} - \sqrt{\frac{2I_2}{\beta_2}} \qquad (7)$$

where $\beta_2$ comprises the factor $W_2/L_2$ which is identical for both transistor $T_3$ and $T_4$.

The gain factor is equal to:

$$A = \frac{V_T}{V_{in}} \qquad (8)$$

Substitution of (1), (3), (5), and (7) yields that:

$$A = \frac{V_T}{V_{in}} = \frac{1}{\sqrt{k}} \qquad (9)$$

When MOS transistors are realised in modern technology, the channel dimensions are so small and the field strengths in the channel are consequently so large that the average electron mobility $\mu_n$ in formula (2) is no longer a constant value, but becomes dependent on the voltage difference $(V_{GS} - V_T)$. For $\mu_n$ then holds that:

$$\mu_n = \frac{\mu_o}{1 + \theta (V_{GS} - V_T)} \qquad (10)$$

where $\theta$ is a mobility reduction factor which is approximately equal to $0.2$ $V^{-1}$. This mobility reduction factor $\theta$ in its turn depends on the channel dimension factor W/L. This should be taken to mean that formula 9 generally no longer holds. The gain factor A is in first instance equal to

$$\sqrt{\frac{\beta_2}{\beta_1}} ,$$

due to the unequal mobility reduction factors $\theta_1$ and $\theta_2$ in (10) for (3) and shows that and $\beta_1$ $\beta_2$ have a value depending on the gate-source voltage $V_{GS}$ which causes distortion to occur. The invention compensates for this in that the transistors $T_1$ up to $T_4$ inclusive are all selected to be identical, so that $V_{GS_1} = V_{GS_2}$ and $V_{GS_3} = V_{GS_4}$, $\beta_2$ is then identical with $\beta_1$. This avoids distortion but it does have the disadvantage of the gain A being equal to one, because K = 1.

In accordance with the invention the embodiment shown in Fig. 1 comprises an operational amplifier 4 whose inputs are connected to the drain electrodes of the transistors $T_1$ and $T_3$ and whose output, on one hand, forms the output 5 carrying output voltage $V_{out}$ of the amplifier and, on the other, through a series combination of a first resistor $R_1$ and a second resistor $R_2$, is connected to ground. The junction of the resistors $R_1$ and $R_2$ is connected to the gate electrode of the fourth MOSFET transistor $T_4$.

Since the operational amplifier 4 continues to keep the voltages of the source electrodes of the transistors $T_2$ and $T_4$ equal to each other and since all the transistors are identical, the following holds:

$$V_{out} \cdot \frac{R_2}{R_1 + R_2} = V_{GS_2} - V_{GS_4} = V_{GS_1} - V_{GS_3} = V_{in}$$

(11)

The gain of the amplifier circuit is therefore equal to:

$$A = \frac{V_{out}}{V_{in}} = \left( 1 + \frac{R_2}{R_1} \right)$$

The factor $\theta$ is eliminated and, therefore, the distortion is very low. In addition, the noise of this amplifier is determined by the resistance ratio $R_1/R_2$ and is therefore low too. Besides, all input current of this amplifier is fully used, so that the amplifier needs to have little power. Furthermore, the gain factor does not depend on the threshold voltage $V_T$, although the amplifier circuit has a single-ended output.

The amplifier circuit shown in Fig. 2 comprises a differential amplifier 4 known *per se*. This amplifier comprises what is commonly referred to as a long tailed pair circuit, formed by the mutually identical MOSFET transistors $T_5$ and $T_7$ whose source electrodes are interconnected and connected to ground *via* a current source 8. These transistors are complementary to the further transistors of the amplifier. The load of this long tailed pair circuit is formed by a current source circuit comprising a transistor $T_6$ included in a third series combination with transistor $T_5$, and a transistor $T_8$ arranged as a diode and included in a fourth series combination with transis-

tor $T_7$, the gate electrodes of the transistors $T_6$ and $T_8$ being interconnected and the source electrodes of these transistors $T_6$ and $T_8$ being interconnected and connected to the positive terminal 9 of a power supply source (not shown). In addition, the operational amplifier 4 comprises an output transistor $T_9$ whose source electrode is connected to the positive supply terminal 9 and whose drain electrode forms the output 5 of the amplifier circuit.

A differential current caused by the input voltage $V_1$ is applied from transistor $T_5$ to transistor $T_9$ as a control voltage and presented as an amplified version on output terminal 5.

The use of this differential amplifier 4 in the amplifier circuit according to the invention provides that voltage shifts are not necessary for realising the amplifier circuit. The amplifier circuit is therefore pre-eminently suitable for operation with a very low supply voltage. For realising an optimum drive of the amplifier circuit, it is possible to compensate for the voltage drop across the current source 7 at the gate electrode of the second transistor $T_2$ in that a reference voltage coming from a DC voltage source 10 is supplied.

## Claims

1. MOS technology amplifier circuit comprising a first series combination of the main current paths of a first ($T_1$) and a second ($T_2$) MOS transistor, the input (2) of the amplifier circuit being coupled to the gate electrode of the first transistor, an output (5) of the amplifier circuit being coupled to the drain electrode of the first transistor and the gate electrode of the second transistor being coupled to the drain electrode of the second transistor, characterized in that the amplifier circuit comprises a second series combination identical with the first series combination and including the main current paths of a third ($T_3$) and a fourth ($T_4$) MOS transistor, another input (3) of the amplifier circuit being coupled to the gate electrode of the third MOS transistor, the source electrodes of the first and third MOS transistors being intercoupled and coupled to a current source (1), the drain electrodes of the second and fourth MOS transistors being intercoupled (7), the drain electrodes of the first and third transistors being connected to a differential amplifier (4, $T_5$-$T_9$), the output of the differential amplifier being coupled the output of the amplifier ($V_{out}$) and also, *via* a series combination of a first ($R_1$) and a second ($R_2$) resistor, to the drain electrodes of the second and fourth MOS transistors, in that the junction of the first and second resistors are coupled to the gate electrode of the fourth transistor and in that the MOS transistors are mutually identical.

2. Amplifier circuit as claimed in Claim 1, characterized in that the differential amplifier circuit comprises a third series combination of the main current paths of a fifth ($T_5$) and a sixth ($T_6$) MOS transistor, a fourth series combination identical with the third series combination and including the main current paths of a seventh ($T_7$) and an eighth ($T_8$) MOS transistor, the source electrodes of the fifth and seventh MOS transistors being interconnected and, via a second current source (8), to the drain electrodes of the second and fourth MOS transistors, the gate electrodes of the fifth and seventh MOS transistors forming the inputs to the differential amplifier, the gate electrodes of the sixth and eighth MOS transistors being intercoupled and coupled to the drain electrode of the eighth MOS transistor, in that the amplifier circuit comprises a ninth MOS transistor ($T_9$) whose source electrode is coupled to the source electrode of the sixth and eighth MOS transistors and a power supply terminal (9), the gate electrode being coupled to the drain electrode of the sixth transistor, in that the drain electrode of the ninth MOS transistor forms the output of the amplifier circuit, and in that the fifth and seventh MOS transistors are complementary to the further MOS transistors.

**Patentansprüche**

1. Verstärkerschaltung in MOS-Technologie mit einer ersten Reihenschaltung aus den Hauptstromstrecken eines ersten (T1) und eines zweiten (T2) MOS-Transistors, wobei der Eingang (2) der Verstärkerschaltung mit der Gate-Elektrode des ersten Transistors gekoppelt ist, wobei ein Ausgang (5) der Verstärkerschaltung mit der Drain-Elektrode des ersten Transistors gekoppelt ist und wobei die Gate-Elektrode des zweiten Transistors mit der Drain-Elektrode desselben gekoppelt ist, dadurch gekennzeichnet, daß die erfindungsgemäße Verstärkerschaltung eine der ersten Reihenschaltung entsprechende zweite Reihenschaltung der Hauptstromstrecken eines dritten (T3) und eines vierten (T4) MOS-Transistors aufweist, wobei ein anderer Eingang (3) der Verstärkerschaltung mit der Gate-Elektrode des dritten MOS-Transistors gekoppelt ist, die Source-Elektrode des ersten und dritten MOS-Transistors miteinander und mit einer Stromquelle (1) gekoppelt sind, die Drain-Elektroden des zweiten und vierten MOS-Transistors miteinander gekoppelt sind (7), die Drain-Elektroden des ersten und des dritten Transistors mit einem Differenzverstärker (4, T5 - T9) gekoppelt sind, wobei der Ausgang des Differenzverstärkers mit dem Ausgang des Verstärkers ($V_{out}$) gekoppelt ist und ebenfalls über eine Reihenschaltung aus einem ersten ($R_1$) und einem zweiten ($R_2$) Widerstand mit den Drain-Elektroden des zweiten und vierten MOS-Transistors gekoppelt ist, daß der Verbindungspunkt des ersten mit dem zweiten Widerstand mit der Gate-Elektrode des vierten Transistors gekoppelt ist und daß die MOS-Transistoren einander entsprechen.

2. Verstärkerschaltung nach Anspruch 1, dadurch gekennzeichnet, daß die Differenzverstärkerschaltung eine dritte Reihenschaltung aus den Hauptstromstrecken eines fünften (T5) und eines sechsten (T6) MOS-Transistors, eine der dritten Reihenschaltung entsprechende vierte Reihenschaltung aus den Hauptstromstrecken eines siebenten (T7) und eines achten (T8) MOS-Transistors, wobei die Source-Elektroden des fünften und siebenten MOS-Transistors miteinander und über eine zweite Stromquelle (8) mit den Drain-Elektroden des zweiten und vierten MOS-Transistors gekoppelt sind, wobei die Gate-Elektroden des fünften und siebenten MOS-Transistors den Eingang des Differenzverstärkers bilden, wobei die Gate-Elektroden des sechsten und achten MOS-Transistors miteinander und mit der Drain-Elektrode des achten MOS-Transistors gekoppelt sind, daß die Verstärkerschaltung einen neunten MOS-Transistor (T9) aufweist, dessen Source-Elektrode mit der Source-Elektrode des sechsten und achten MOS-Transistors und mit einer Speiseklemme (9) gekoppelt ist, die Gate-Elektrode mit der Drain-Elektrode des sechsten Transistors gekoppelt ist, daß die Drain-Elektrode des neunten MOS-Transistors den Ausgang der Verstärkerschaltung bildet und daß der fünfte und siebente MOS-Transistor zu den übrigen MOS-Transistoren komplementär sind.

**Revendications**

1. Circuit amplificateur en technique MOS comprenant une première combinaison en série des trajets de courant principaux d'un premier ($T_1$) et d'un deuxième ($T_2$) transistors MOS, l'entrée (2) du circuit amplificateur étant couplée à l'électrode de grille du premier transistor, une sortie (5) du circuit amplificateur étant couplée à l'électrode de drain du premier transistor et l'électrode de grille du deuxième transistor étant couplée à l'électrode de drain du deuxième transistor, caractérisé en ce que le circuit amplificateur comprend une deuxième combinaison en série identique à la première combinaison en série et comprenant les trajets de courant principaux d'un troisième ($T_3$) et d'un quatrième ($T_4$) transistors MOS, une autre entrée (3) du circuit amplificateur étant couplée à l'électrode de grille du troisième transistor MOS, les électrodes de source du premier et du troisième transistors MOS étant intercouplées et couplées à une source de courant (1), les électrodes de drain du deuxième et du quatrième transistors MOS étant intercouplées (7), les électrodes de drain du premier et du troisième transistors étant connectées à un amplificateur différentiel (4, $T_5$-$T_9$), la sortie de l'amplificateur différentiel étant couplée à la sortie de l'amplificateur ($V_{out}$) et, via une combinaison en série d'une première ($R_1$) et d'une deuxième ($R_2$) résistances, aux électrodes de drain du deuxième et du quatrième transistors MOS, en ce que la jonction de la première et de la deuxième résistances est couplée à l'électrode de grille du quatrième transistor et en ce que les transistors MOS sont mutuellement identiques.

2. Circuit amplificateur suivant la revendication 1, caractérisé en ce que le circuit amplificateur différentiel comprend une troisième combinaison en série des trajets de courant principaux d'un cinquième ($T_5$) et d'un sixième ($T_6$) transistors MOS, une quatrième combinaison en série identique à la troisième combinaison en série et comprenant les trajets de courant principaux d'un septième ($T_7$) et d'un huitième ($T_8$) transistors MOS, les électrodes de source du cinquième et du septième transistors MOS étant interconnectées et, via une deuxième source de courant (8), aux électrodes de drain du deuxième et du quatrième transistors MOS, les électrodes de grille du cinquième et du septième transistors MOS formant les entrées de l'amplificateur différentiel, les électrodes de grille du sixième et du huitième transistors MOS étant intercouplées et couplées à l'électrode de drain du huitième transistor MOS, en ce que le circuit amplificateur comprend un neuvième transistor MOS ($T_9$) dont l'électrode de source est couplée à l'électrode de source du sixième et du huitième transistors MOS et à une borne d'alimentation (9), l'électrode de grille étant couplée à l'électrode de drain du sixième transistor, en ce que l'électrode de drain du neuvième transistor MOS forme la sortie du circuit amplificateur et en ce que le cinquième et le septième transistors MOS sont complémentaires aux autres transistors MOS.

FIG. 1

FIG.2